# EUROPEAN PATENT APPLICATION

(11) **EP 1 128 413 A1**
(43) Date of publication of application: **29.08.2001**
(21) Application number: 01301386.7
(22) Date of filing: 16.02.2001
(51) Int. Cl.: H01J 37/28, H01J 37/26

(54) **Method of observing image and scanning electron microscope**

(30) Priority: 24.02.2000 JP 2000047001
(71) Applicant: Jeol Ltd., Akishima, Tokyo 196-8558 (JP); Jeol Technics Ltd., Tokyo, 196-8558 (JP)
(72) Inventor: Tsuyuki, Makoto, Hachioji, Tokyo 192-0914 (JP)
(74) Representative: Cross, Rupert Edward Blount

(57) **Abstract**

An image observation method and a scanning electron microscope (SEM) are described which permit anyone to observe an SEM image under optimum conditions adapted for the specimen kind and purpose of the observation. The microscope has a memory in which accelerating voltage ranges and spot size ranges corresponding to specimen kinds, accelerating voltage ranges and spot size ranges corresponding to specimen kinds and specimen surface states, ranges of spot sizes corresponding to magnifications, and accelerating voltage ranges and spot size ranges corresponding to analyzing means are previously stored. When an operator wants to make a certain observation on the scanning electron microscope, he or she first selects an observation mode adapted for the purpose of the observation, using a pointing device. A controller then controls a display control circuit to display a condition-selecting menu on the viewing screen of a display device. The operator selects necessary conditions from the condition-selecting menu. Then, observation conditions optimal in the selected conditions are read from the memory. The controller controls the electron optics according to the observation conditions.

## Description

### BACKGROUND OF THE INVENTION

### 1. Field of the Invention

The present invention relates to image observation method and scanning electron microscope used in scanning electron microscopy in which an image can be observed under optimum conditions according to the kind of specimen and the purpose of the observation.

### 2. Description of the Related Art

In a scanning electron microscope, an electron beam that is produced by an electron gun and accelerated is sharply focused onto a specimen by condenser lenses and an objective lens. Secondary electrons and reflected electrons produced as a result of scanning of the electron beam are detected. The resulting signal is fed as an image signal to a cathode-ray tube (CRT) synchronized with the scanning of the electron beam. Consequently, a two-dimensional image of the specimen is displayed on the CRT exhibiting afterglow.

Where a specimen image is observed on such a scanning electron microscope, it is desired to make observations under observation conditions adapted for the specimen. The observation conditions include the accelerating voltage at which the electron beam directed to the specimen is accelerated and the spot size of the electron beam on the specimen. In this case, how various values are set under what observation conditions depends only on operator's experience.

In particular, if the specimen is a metal, the accelerating voltage for the electron beam is increased. If the specimen is a biological one, the accelerating voltage is decreased. If the specimen surface is coated with a conductive material, a high accelerating voltage is selected. If the specimen surface is not coated, a low accelerating voltage is selected.

Furthermore, when an observation is made at a high magnification, the spot size of the electron beam impinging on the specimen is reduced. On the other hand, when an observation is made at a low magnification, the spot size is increased. Additionally, the observation conditions must be set optimally depending on other purposes, e.g., whether an elemental analysis of a specific portion on the specimen is performed or not.

Specimens observed on a scanning electron microscope are numerous in kind. Furthermore, there are many purposes in observing specimens. In the past, the operator has found observation conditions by trial and error while replying on his or her experience according to the specimen and purpose of observation. Then, the desired observation is made. Accordingly, the instrument is not always easy to handle, and it has been unlikely that anyone can use a scanning electron microscope under optimum conditions adapted for the kind of the specimen and for the purpose of observation.

### SUMMARY OF THE INVENTION

In view of the foregoing, the present invention has been made. It would be desirable to have a scanning electron microscope (SEM) and image observation method permitting anyone to observe an SEM image under optimum conditions adapted for the kind of the specimen and for the purpose of observation.

A method of observing an image on a scanning electron microscope in accordance with the present invention uses the scanning electron microscope having an electron gun for producing and accelerating an electron beam, focusing means for focusing the electron beam onto a specimen, scanning means for scanning the electron beam across the specimen, a detector for detecting a signal obtained as a result of incidence of the electron beam onto the specimen, and a display means for displaying an image of the specimen in response to the output signal from the detector. This method starts with storing electron beam accelerating voltages and spot sizes on the specimen best suited for combinations of at least specimen kinds, specimen surface states, and magnifications (hereinafter often simply referred to as the magnification) of the final image in a memory. An operator enters a combination of a kind of specimen to be observed, a specimen surface state, and a magnification of the final image through input means. Thus, an accelerating voltage and a spot size corresponding to the combination are read from the memory. The electron gun is controlled according to the accelerating voltage read out in this way. The focusing means are controlled according to the spot size read out.

A scanning electron microscope in accordance with the present invention has an electron gun for producing and accelerating an electron beam, focusing means for focusing the electron beam onto a specimen, scanning means for scanning the electron beam across the specimen, a detector for detecting a signal produced as a result of incidence of the electron beam onto the specimen, and a display means for displaying an image of the specimen according to the detected signal. This scanning electron microscope is characterized in that it includes a memory, a selecting means, and a control means. Optimum electron beam accelerating voltages and spot sizes on the specimen surfaces which correspond to combinations of at least kinds of specimens, states of specimen surfaces, and magnifications of the final image are stored in the memory. The selecting means selects a combination of a kind of specimen to be observed, a specimen surface state, and a magnification of the final image. The control means reads an accelerating voltage and a spot size corresponding to the combination selected by the selecting means from the memory, and controls the electron gun and the focusing means according to the accelerating voltage and spot size read from the memory.

Embodiments of the invention will appear in the course of the description thereof, which follows.

### BRIEF DESCRIPTION OF THE DRAWINGS

Fig. 1 is a block diagram of a scanning electron microscope in accordance with the present invention;
Fig. 2 is a diagram showing an example of a checklist displayed on the viewing screen of the display device of the microscope shown in Fig. 1;
Fig. 3 is a diagram showing an example of data displayed on the viewing screen of the display device of the microscope shown in Fig. 1; and
Fig. 4 is a diagram showing an example of a menu displayed on the viewing screen of the display device of the microscope shown in Fig. 1.

### DESCRIPTION OF THE PREFERRED EMBODIMENTS

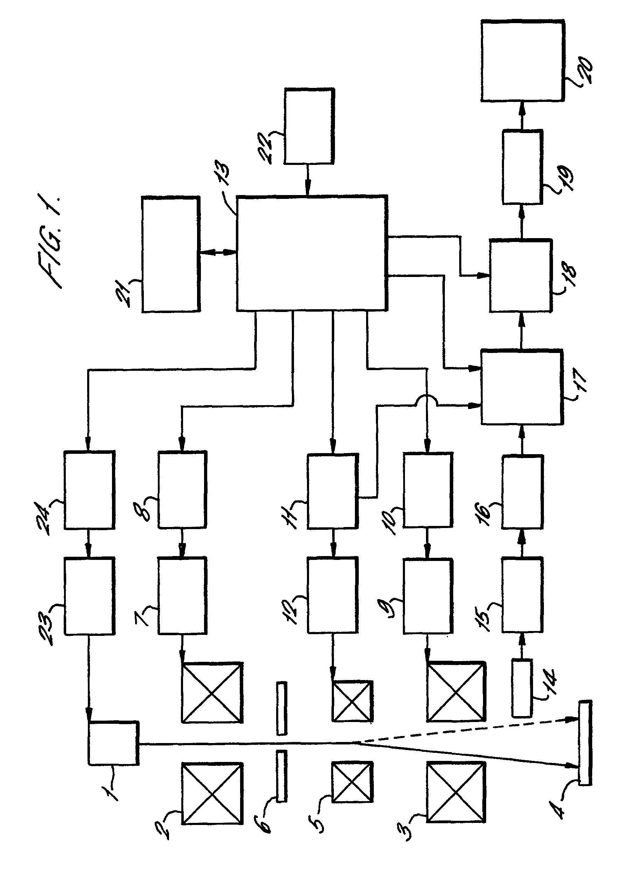

Referring to Fig. 1, there is shown a scanning electron microscope in accordance with the present invention. This microscope has an electron gun 1 for producing an electron beam EB that is sharply focused onto a specimen 4 by condenser lenses 2 and an objective lens 3. The electron beam EB is deflected by a deflector 5 such as scanning coils or electrostatic deflectors. The specimen 4 is scanned by the electron beam.

An objective aperture 6 is disposed under the condenser lenses 2. An exciting current is supplied to the condenser lenses 2 from a power supply 7. The amplitude of this exciting current is controlled by a control circuit 8. An exciting current is supplied to the objective lens 3 from a power supply 9. The amplitude of this exciting current is controlled by a control circuit 10.

A two-dimensional scan signal is supplied to the deflector 5 from a scan signal-generating circuit 11 via a scanning driver circuit 12. The control circuit 8 for the power supply 7, the control circuit 10 for the power supply 9, and the scan signal-generating circuit 11 are controlled by a controller 13 such as a computer.

As the electron beam EB hits the specimen 4, secondary electrons are produced. These secondary electrons are detected by a secondary electron detector 14. The output signal from the secondary electron detector 14 is amplified by an amplifier 15 and converted into a digital signal by an analog-to-digital converter (ADC) 16. The output signal from the A/D converter 16 is supplied to a frame memory 17 and stored there according to the scan signal.

The video signal stored in the frame memory 17 is read out and sent via a display control circuit 18 to a digital-to-analog converter (DAC) 19, where the signal is converted into an analog signal. This analog signal is supplied to a display device 20. A memory 21 and a pointing device 22 such as a mouse are connected with the controller 13. The operation of the instrument constructed in this way is described below.

Where a secondary electron image is observed, the electron beam from the electron gun 1 is sharply focused onto the specimen 4 by focusing means consisting of the condenser lenses 2 and the objective lens 3. The beam is scanned across a desired region in two dimensions on the specimen by the deflector 5. Incidence of the electron beam EB onto the specimen 4 produces secondary electrons, which are detected by the detector 14. The output signal from the detector 14 is amplified by the amplifier 15 and supplied via the analog-to-digital converter 16 to the frame memory 17, where the signal is stored.

The signal stored in the frame memory 17 is read out and supplied to the display device 20 via the display control circuit 18 and via the D/A converter 19. As a result, a secondary electron image of the specimen is displayed on the display device 20.

The accelerating voltage for the electron beam EB directed to the specimen 4 and the spot size of the electron beam on the specimen have their optimum ranges according to the specimen kind, the state of the specimen surface (i.e., whether it is coated or not) , the magnification, the purpose of observation (i.e., whether it is analyzed or not), and analyzing means.

Accelerating voltage ranges and spot size ranges corresponding to specimen kinds, accelerating voltage ranges and spot size ranges corresponding to specimen kinds and specimen surface states, ranges of spot sizes corresponding to magnifications, and accelerating voltage ranges and spot size ranges corresponding to analyzing means (i.e., whether EDS or WDS analysis is made) are previously stored in the memory 21.

When a certain observation should be made using the scanning electron microscope, the operator first selects a mode of operation for indicating the purpose of observation using the pointing device 22. Then, the controller 13 causes the display control circuit 18 to display a condition-selecting menu on the viewing screen of the display device 20.

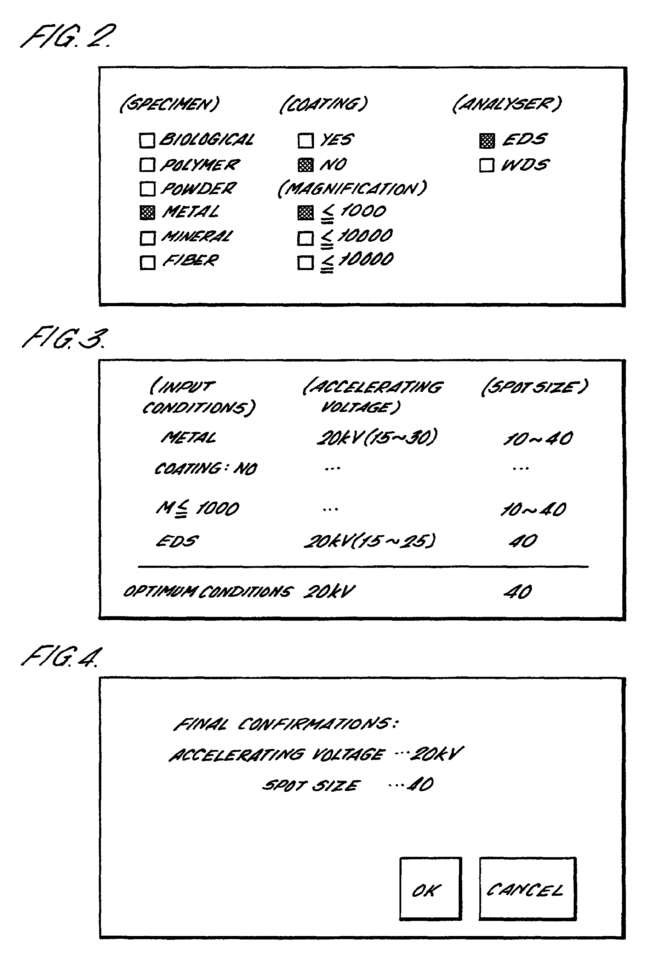

Fig. 2 shows an example of the condition-selecting menu. The operator selects desired observation conditions using the pointing device 22. For instance, "metal" is selected as the specimen kind. "NO" is selected regarding coating. With respect to the magnification, "under 1000x" is selected. With respect to analysis, "EDS" is selected.

If such a selection of conditions is made, the controller 13 reads a range of accelerating voltages and a range of spot sizes from the memory 21, the ranges being appropriate under the selected conditions. The contents are displayed on the display device 20 via the display control circuit 18. Fig. 3 shows one example of the displayed contents on the viewing screen of the display device.

In Fig. 3, the kind of specimen included in the input conditions is a metal. Therefore, the optimum value of the accelerating voltage is shown to be 20 kV. The tolerable range is shown to be 15 to 30 kV. The optimum range of spot sizes is shown to be 10 to 40. In this example, "0" of the spot size indicates the minimum spot diameter, while "99" indicates the maximum spot diameter. Since the set conditions are that the specimen is a metal and is not coated, none of the accelerating voltage and the spot size have any special range.

Because the selected magnification is "under 1000x", the optimum range of spot sizes is shown to be 10 to 40. "EDS analysis" is selected as the analysis. The tolerable range of accelerating voltages is shown to be 15 to 25 kV, and the optimum value is shown to be 20 kV. "40" of spot size is shown to be optimal. The controller 13 calculates final optimum values under the entered conditions from the various values read from the memory 21. The contents (i.e., the accelerating voltage is 20 kV and the spot size is 40) are displayed.

After the contents are displayed as shown in Fig. 3, a menu for final settings is displayed on the display device 20. If the operator clicks on "OK" menu item using the pointing device 22, the controller 13 controls the various components of the scanning electron microscope under the set conditions.

Since the accelerating voltage is set to 20 kV, the controller 13 controls the control circuit 24 accordingly, the control circuit 24 providing control of the accelerating voltage source 23 of the electron gun 1. The accelerating voltage at which electron beam EB emitted from the electron gun 1 and directed to the specimen 4 is accelerated is set to 20 kV.

Furthermore, the controller 13 controls the control circuits 8 and 10, adjusting the exciting currents supplied to the condenser lenses 2 and to the objective lens 3, respectively. Thus, the spot size of the electron beam EB on the specimen 4 is set to 40.

After completion of adjustments of the electron optics as described above, observation of the aforementioned secondary electron image or an EDS analysis of the specimen using an EDS detector (not shown) is carried out.

In the example described above, the observation conditions are electron beam accelerating voltage and spot size of the beam on the specimen. Preferably, other conditions such as specimen tilt angle, working distance, kind of detector (e.g., reflection electron detector or secondary electron detector), and vacuum mode (i.e., the vacuum is a high vacuum or a low vacuum) can also be set.

In this case, in the instrument shown in Fig. 1, electron beam accelerating voltages, spot sizes on the specimen, specimen tilt angles, working distances, kinds of detector, and vacuum modes that are optimal at combinations of specimen kinds, states of the specimen surface, and magnifications of the final image are stored in the memory 21. A combination of a specimen kind, a state of the specimen surface, and a magnification is selected using the pointing device 22. Thus, the controller 13 reads electron beam accelerating voltage, spot size on the specimen, specimen tilt angle, working distance, detector kind, and vacuum mode corresponding to the combination from the memory 21. The controller 13 controls the electron gun 1 according to the accelerating voltage read out. Furthermore, the controller 13 controls the focusing means according to the spot size. In addition, the controller 13 controls the tilt angle of the specimen stage according to the specimen tilt angle. Moreover, the controller 13 controls the Z motion of the specimen stage according to the working distance. The controller switches the detector according to the kind of detector. Also, the controller controls the pumping means according to the vacuum mode.

While one embodiment of the present invention has been described thus far, the invention is not limited thereto. For example, in the above embodiment, a window in the form of a checklist as shown in Fig. 2 is displayed to urge the operator to select desired items from the menu items in the window. In this way, an observed object and the purpose of observation are entered. It is to be noted that the invention is not limited to this method. Kind of specimen, presence or absence of coating, magnification, purpose of observation, and so forth may be directly entered from a keyboard or the like.

As described thus far, in the embodiments set forth in claims 1 and 3, optimum electron beam accelerating voltages and spot sizes on the specimen corresponding to combinations of at least specimen kinds, states of specimen surface, and magnifications are stored in a memory. The operator enters a combination of a specimen kind to be observed, a specimen surface state, and a magnification of the final image through an input means. An accelerating voltage and a spot size corresponding to the combination are read from the memory. The electron gun is controlled according to the accelerating voltage read out. The focusing means is controlled according to the spot size. Consequently, anyone can make an observation on the scanning electron microscope under optimum observation conditions.

In the embodiments set forth in claims 2 and 4, the accelerating voltage and the spot size are controlled. In addition, at least one of specimen tilt angle, working distance, detector kind, and vacuum mode is controlled according to the combination of the specimen kind, specimen surface state, and magnification of the final image.

The embodiment set forth in claim 5 is based on the embodiment set forth in claim 3 or 4 and characterized in that a selecting means displays the specimen kind to be observed, the specimen surface state, and the magnification on the viewing screen of a display device. The operator selects a desired one of the displayed items. Hence, the operator can easily select a desired object to be observed.

## Claims

1. A method of observing an image on a scanning electron microscope having an electron gun for producing and accelerating an electron beam, focusing means for focusing the electron beam onto a specimen, scanning means for scanning the electron beam across the specimen, a detector for detecting a signal obtained as a result of incidence of the electron beam onto the specimen, and a display means for displaying an image of the specimen in response to the output signal from the detector, said method comprising the steps of:
storing electron beam accelerating voltages and spot sizes on the specimen which are optimal at combinations of at least kinds of the specimen, surface states of the specimen, and magnifications in a memory;
entering a combination of a kind of specimen to be observed, a surface state of specimen, and a magnification of the final image through input means to thereby read an accelerating voltage and a spot size corresponding to the combination from the memory;
controlling said electron gun according to the accelerating voltage read out; and
controlling said focusing means according to the spot size read out.

2. A method of observing an image on a scanning electron microscope as set forth in claim 1, further comprising the steps of:
storing at least one of specimen tilt angle, working distance, detector kind, and vacuum mode in a memory according to a combination of a specimen kind, a specimen surface state, and a magnification;
causing the operator to enter a combination of a specimen kind to be observed, a specimen surface state, and a magnification through the input means to read a specimen tilt angle, a working distance, a detector kind, or a vacuum mode corresponding to the entered combination from the memory; and
controlling corresponding configurations according to information read from the memory.

3. A scanning electron microscope comprising:
an electron gun for producing and accelerating an electron beam;
focusing means for focusing the electron beam onto a specimen;
scanning means for scanning the electron beam across the specimen;
a detector for detecting a signal obtained as a result of incidence of the electron beam onto the specimen;
a display means for displaying an image of the specimen in response to an output signal from the detector;
a memory in which optimum electron beam accelerating voltages and spot sizes on the specimen surfaces which correspond to combinations of at least kinds of specimens, states of specimen surfaces, and magnifications of final image are stored;
a selecting means for selecting a combination of a kind of specimen to be observed, a state of specimen surface, and a magnification of the final image; and
a control means for reading an accelerating voltage and a spot size corresponding to the combination selected by the selecting means from the memory and controlling the electron gun and the focusing means according to the accelerating voltage and spot size, respectively, read from the memory.

4. The scanning electron microscope of claim 3, wherein at least one of specimen tilt angle, working distance, detector kind, and vacuum mode is also stored in the memory in association with combinations of specimen kinds, specimen surface states, and magnifications, and wherein said control means reads a specimen tilt angle, a specimen surface state, or a detector kind corresponding to the combination of a specimen kind, a specimen surface state, and a magnification selected by the selecting means from the memory and controls corresponding configurations according to information read out.

5. The scanning electron microscope of claim 3 or 4, wherein said selecting means displays a specimen kind to be observed, a specimen surface state, and a magnification on the viewing screen of a display device and urges an operator to select a corresponding one or ones of the displayed items.
